# EUROPEAN PATENT APPLICATION

(11) **EP 4 804 238 A1**
(43) Date of publication of application: **09.09.2026**
(21) Application number: 24884481.3
(22) Date of filing: 21.10.2024
(51) Int. Cl.: H01L 23/31

(54) **HYBRID PACKAGE-ON-PACKAGE STRUCTURE**

(30) Priority: 30.10.2023 CN 202311423381
(71) Applicant: Spreadtrum Communications (Shanghai) Co., Ltd., Shanghai 201203 (CN)
(72) Inventor: LIU, Mengqi, Shanghai 201203 (CN); QIU, Yuanhong, Shanghai 201203 (CN); TIAN, Fuyou, Shanghai 201203 (CN); YAO, Li, Shanghai 201203 (CN); CHEN, Si, Shanghai 201203 (CN)
(74) Representative: Casalonga
(86) International application number: PCT/CN2024/126054
(87) International publication number: WO 2025/092477

(57) **Abstract**

Provided in the present disclosure is a hybrid Package-on-Package structure. The Package-on-Package structure comprises: a memory, which has signal cells used for transmitting signals; and an adapter board, which has a first surface and a second surface arranged opposite each other, wherein the first surface faces the memory; the second surface faces an SOC substrate; first-type solder balls arranged in a first direction and second-type solder balls arranged in a second direction are provided on the second surface; the first-type solder balls are connected to the signal cells of the memory and are configured for the signal fan-out of the memory; the second-type solder balls are configured to support the adapter board and the SOC substrate, the second-type solder balls are divided into a plurality of solder ball groups, and the spacing between adjacent solder ball groups in the second direction is greater than the spacing between adjacent second solder balls in the solder ball groups; and the first direction is different from the second direction; and the SOC substrate is in signal connection with the first-type solder balls. By means of the solution, the adapter board and the SOC substrate can be supported; moreover, the mold flow filling yield can be improved and the package layout design of the SOC substrate is facilitated.

## Description

The present application claims priority to CN Patent Application No. 202311423381.X, entitled "HYBRID PACKAGE-ON-PACKAGE STRUCTURE", and filed with the China National Intellectual Property Administration on October 30, 2023, the entity of which is incorporated herein by reference.

### TECHNICAL FIELD

Embodiments of the present application relate to the field of packaging technology, and in particular, to a hybrid Package-on-Package structure.

### BACKGROUND

In a conventional Package-on-Package (PoP), signal bumps of a memory appear on periphery of a memory package, which can be directly bonded to an SOC substrate. The memory may be a Low Power Double Data Rate SDRAM (LPDDR). In an example where the memory is LPDDR, as the number of signal bumps of the LPDDR increases and the LPDDR package size grows, the signal bumps gradually appear interior to the package, giving rise to a hybrid Package-on-Package (Hybrid PoP).

In the design and process of the Hybrid PoP package, a layout design of solder balls under an interposer (also known as an interposer substrate) will directly affect package layout design of a chip fan-out routing strategy of an SOC substrate. It may also directly affect a process yield of Mold Flow (MD), such as void formation after MD molding, as well as uniformity of Stand-Off Height (SOH) values of inter-stack solder balls after reflow following Thermal Compression Bonding (TCB). However, the current Hybrid PoP package design cannot solve all the above problems simultaneously.

### SUMMARY

Embodiments of the present application address the problem that the existing Hybrid PoP package design cannot solve the molding effect, the package layout design of the SOC substrate, and the uniformity of stand-off height after reflow simultaneously.

To solve the above technical problem, an embodiment of the present application provides a hybrid Package-on-Package structure, which comprises: a memory with signal bumps for transmitting signals; an interposer with a first surface and a second surface opposite to each other, the first surface towards the memory, the second surface towards an SOC substrate, wherein the second surface is disposed with first-type solder balls arranged along a first direction and second-type solder balls arranged along a second direction, the first-type solder balls being connected to the signal bumps of the memory, the first-type solder balls being used for signal fan-out from the memory, the second-type solder balls being used for supporting the interposer and the SOC substrate, wherein the second-type solder balls are divided into a plurality of solder ball groups, each solder ball group including one or more second solder balls, a spacing between adjacent solder ball groups being greater than a spacing between adjacent second solder balls in the solder ball group along the second direction, wherein the first direction is different from the second direction; the SOC substrate, which is in signal connection with the first-type solder balls.

Optionally, the first direction is perpendicular to the second direction.

Optionally, the second surface of the interposer has a first periphery region and a second periphery region opposite to each other, wherein the first-type solder balls are located in the first periphery region and the second periphery region; and/or, the second surface of the interposer has a third periphery region and a fourth periphery region opposite to each other, wherein the second-type solder balls are located in the third periphery region and the fourth periphery region.

Optionally, cross-sections of the second-type solder balls in a direction parallel to the second surface are circular, dog-bone shaped, or elliptical.

Optionally, the first-type solder balls are spherical, the cross-sections of the second-type solder balls in the direction parallel to the second surface are dog-bone shaped, wherein the second-type solder balls have long sides extending along the second direction, the long sides of the second-type solder balls having lengths greater than a diameter of the first-type solder ball; or, the cross-sections of the second-type solder balls in the direction parallel to the second surface are elliptical, wherein the second-type solder balls have long axes extending along the second direction, the long axes of the second-type solder balls having lengths greater than the diameter of the first-type solder ball.

Optionally, the cross-sections of the second-type solder balls in the direction parallel to the second surface are dog-bone shaped, the second-type solder balls having short sides with lengths smaller than the diameter of the first-type solder ball; or, the cross-sections of the second-type solder balls in the direction parallel to the second surface are elliptical, the second-type solder balls having short axes with lengths smaller than the diameter of the first-type solder ball.

Optionally, the second-type solder balls are formed by an automatic ball placement process; or, the second-type solder balls are formed by an electroplated ball process.

Optionally, solder ball parameters of the first-type solder balls and solder ball parameters of the second-type solder balls are determined based on at least one of the following parameters: a number of the signal bumps of the memory, a layout of the signal bumps of the memory, a trace width of the interposer, a trace pitch of the interposer, and a package size of the interposer.

Optionally, the second-type solder balls are arranged in one or more columns along the second direction.

Optionally, the second-type solder balls are arranged in multiple columns along the second direction, for two adjacent columns of the second-type solder balls, a spacing between adjacent solder ball groups in a column close to a center of the interposer being denoted as a first spacing, and a spacing between adjacent solder ball groups in a column close to an edge of the interposer being denoted as a second spacing, wherein a projection of the first spacing along the first direction is covered by a projection of the second spacing along the first direction.

Compared with the prior art, the technical solutions of the embodiments of the present application have the following beneficial effects.

A second surface of the interposer is disposed with first-type solder balls arranged along a first direction and second-type solder balls arranged along a second direction, wherein the first direction is different from the second direction. The first-type solder balls are connected to the signal bumps of the memory and are in signal connection with the SOC substrate, to fan out signals from the memory to the SOC substrate. The second-type solder balls serve to support the interposer and the SOC substrate. The second-type solder balls are divided into a plurality of solder ball groups, each solder ball group including one or more second solder balls. The spacing between adjacent solder ball groups along the second direction is greater than the spacing between adjacent second solder balls in a solder ball group. Thus, the second-type solder balls can provide support for the interposer and the SOC substrate to ensure uniform stand-off height after reflow, and can also allow rapid passage of mold flow during the molding process by reducing resistance to the mold flow, so as to facilitate the mold filling, reduce the likelihood of void formation, and improve the molding yield. In addition, the spacing between adjacent solder ball groups can also provide a layout space, facilitating the layout design of the SOC substrate package.

### BRIEF DESCRIPTION OF THE DRAWINGS

FIG. 1 is a schematic diagram of a conventional interposer;
FIG. 2 is a schematic diagram of another conventional interposer;
FIG. 3 is a schematic structural diagram of a hybrid Package-on-Package structure from a perspective in an embodiment of the present application;
FIG. 4 is a schematic structural diagram of a hybrid Package-on-Package structure from another perspective in an embodiment of the present application;
FIG. 5 is a schematic diagram of an interposer in an embodiment of the present application;
FIG. 6 is a schematic diagram of another interposer in an embodiment of the present application;
FIG. 7 is a schematic diagram of another interposer in an embodiment of the present application;
FIG. 8 is a schematic diagram of yet another interposer in an embodiment of the present application;
FIG. 9 is a schematic flowchart of forming second-type solder balls by the automatic ball placement process;
FIG. 10 is a schematic process diagram of forming second-type solder balls by the automatic ball placement process;
FIG. 11 is a schematic flowchart of forming second-type solder balls by the electroplated ball process;
FIG. 12 is a schematic process diagram of forming second-type solder balls by the electroplated ball process.

Description of Numerals:
1 - memory; 11 - signal bump; 2 - interposer; 21 - first surface; 22 - second surface; 221 - first periphery region; 222 - second periphery region; 223 - third periphery region; 224 - fourth periphery region; 23 - first-type solder ball; 231 - first solder ball; 24 - second-type solder ball; 240 - solder ball group; 241 - second solder ball; 3 - SOC substrate; 4 - flux pot; 5 - stencil; 51 - aperture; 6 - solder paste; 7 - flux; x - first direction; y - second direction.

### DETAILED DESCRIPTION

As mentioned above, in the design and process of the Hybrid PoP package, the layout design of solder balls under the interposer will directly affect the package layout design of the chip fan-out routing strategy of the SOC substrate. It may also directly affect the process yield of Mold Flow (MD), such as void formation after MD molding, as well as uniformity of the Stand-Off Height (SOH) values of inter-stack solder balls after reflow following Thermal Compression Bonding (TCB).

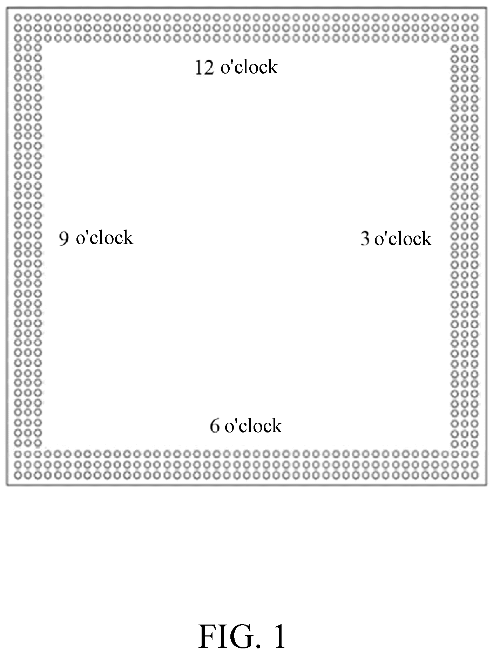

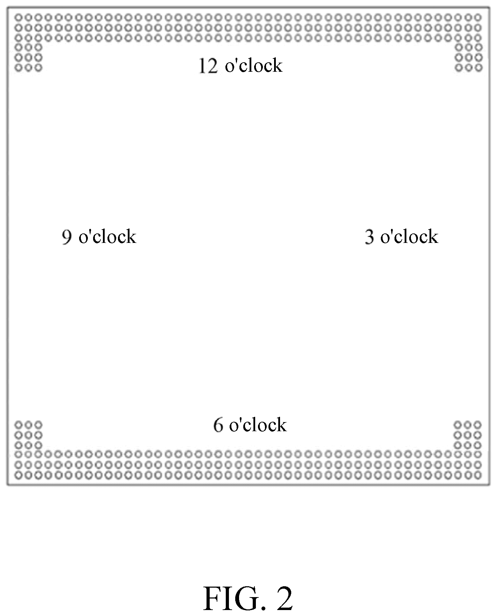

Refer to FIG. 1, which shows a schematic diagram of a conventional interposer. In specific, the interposer has solder balls (also known as inter-stack solder balls) at the 3 o'clock and 9 o'clock directions for supporting the interposer and the SOC substrate, and solder balls at the 6 o'clock and 12 o'clock directions for signal fan-out. In the prior art, the solder balls at the 3 o'clock and 9 o'clock directions and the solder balls at the 6 o'clock and 12 o'clock directions have the same spacing, and are arranged in multiple rows. Studies have found that if there are excessive inter-stack solder balls on both the 3 o'clock and 9 o'clock sides, these solder balls would obstruct the package fan-out routing for signals from other modules of the SOC chip on these two sides of the SOC substrate, thereby limiting the quality and quantity of signal routing for the SoC chip on these two sides. In addition, these solder balls will obstruct the mold flow during molding process, resulting in void formation. As shown in FIG. 2, if the solder balls at the 3 o'clock and 9 o'clock directions are removed, the total SOH height of inter-stack solder balls cannot be guaranteed, affecting the uniformity of stand-off height. In summary, the current Hybrid PoP package design cannot effectively address the above issues simultaneously.

To address the aforementioned issues, in an embodiment of the present application, a second surface of the interposer is disposed with first-type solder balls arranged along a first direction and second-type solder balls arranged along a second direction, wherein the first direction is different from the second direction. The first-type solder balls are connected to the signal bumps of the memory and are in signal connection with the SOC substrate, to fan out signals from the memory to the SOC substrate. The second-type solder balls serve to support the interposer and the SOC substrate. The second-type solder balls are divided into a plurality of solder ball groups, each solder ball group including one or more second solder balls. The spacing between adjacent solder ball groups along the second direction is greater than the spacing between adjacent second solder balls in a solder ball group. Thus, the second-type solder balls can provide support for the interposer and the SOC substrate to ensure uniform stand-off height after reflow, and can also allow rapid passage of mold flow during the molding process by reducing resistance to the mold flow, so as to facilitate the mold filling, reduce the likelihood of void formation, and improve the molding yield. In addition, the spacing between adjacent solder ball groups can also provide a layout space, facilitating the layout design of the SOC substrate package.

To make the above objectives, features and beneficial effects of the embodiments of the present application more obvious and understandable, specific embodiments of the present application will be described in details below with reference to the drawings.

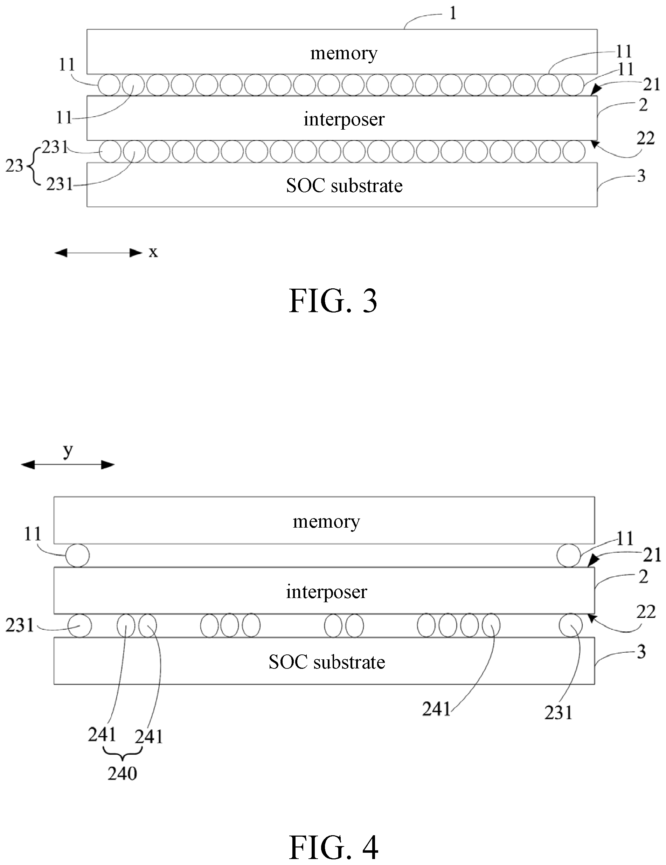

In an embodiment of the present application, a hybrid Package-on-Package structure is provided, as shown in FIGs. 3 to 8. The hybrid Package-on-Package structure includes: a memory 1, an interposer 2 and an SOC substrate 3. The memory 1 has signal bumps 11 for transmitting signals.

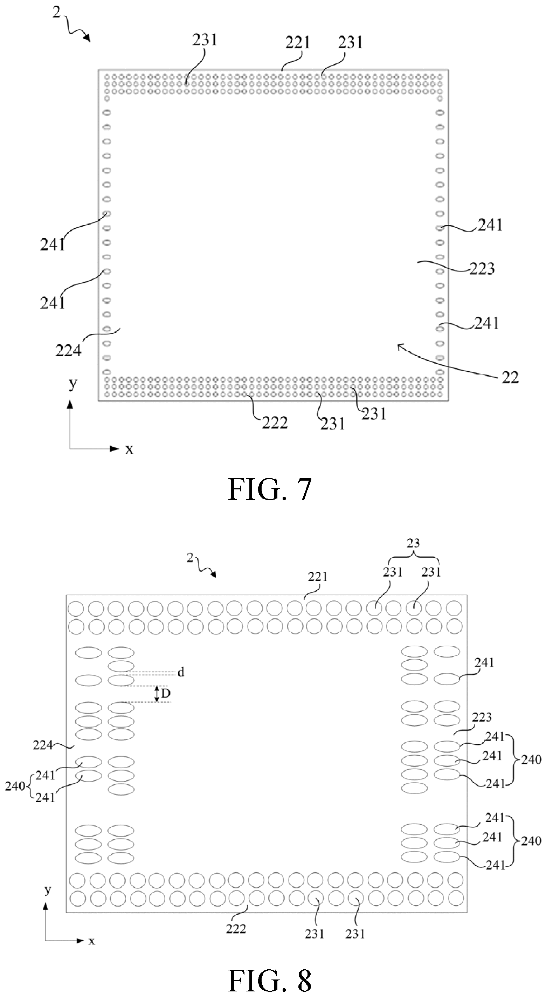

The interposer 2 has a first surface 21 and a second surface 22 opposite to each other. The first surface 21 is towards the memory 1. The second surface 22 is towards the SOC substrate 3. The second surface 22 is disposed with first-type solder balls 23 arranged along a first direction x and second-type solder balls 24 arranged along a second direction y. The first-type solder balls 23 are connected to the signal bumps 11 of the memory 1. The first-type solder balls 23 are used for signal fan-out of the memory 1. The second-type solder balls 24 are used for supporting the interposer 2 and the SOC substrate 3. The second-type solder balls 24 are divided into a plurality of solder ball groups 240, each solder ball group 240 including one or more second solder balls 241. Along the second direction y, the spacing D between adjacent solder ball groups 240 is greater than the spacing d between adjacent second solder balls 241 in a solder ball group 240. The first direction x is different from the second direction y. The SOC substrate is in signal connection with the first-type solder balls 23. It should be noted that the spacing D between adjacent solder ball groups 240 and the spacing d between adjacent second solder balls 241 are illustrated in schematic in FIG. 8, but not illustrated in other figures.

As above, the second surface 22 of the interposer 2 is disposed with first-type solder balls 23 arranged along the first direction x and second-type solder balls 24 arranged along the second direction y, wherein the first direction x is different from the second direction y. The first-type solder balls 23 are connected to the signal bumps 11 of the memory 1 and are in signal connection with the SOC substrate 3, to fan out signals from the memory 1 to the SOC substrate 3. The second-type solder balls 24 serve to support the interposer 2 and the SOC substrate 3. The second-type solder balls 24 are divided into a plurality of solder ball groups 240, each solder ball group 240 including one or more second solder balls 241. Along the second direction y, the spacing between adjacent solder ball groups 240 is greater than the spacing between adjacent second solder balls 241 in a solder ball group 240. Thus, the second-type solder balls 24 can provide support for the interposer 2 and the SOC substrate 3 to ensure uniform stand-off height after reflow, and can also allow rapid passage of mold flow during the molding process by reducing resistance to the mold flow, so as to facilitate the mold filling, reduce the likelihood of void formation, and improve the molding yield. In addition, the spacing between adjacent solder ball groups 240 can also provide a layout space, facilitating the layout design of the SOC substrate package.

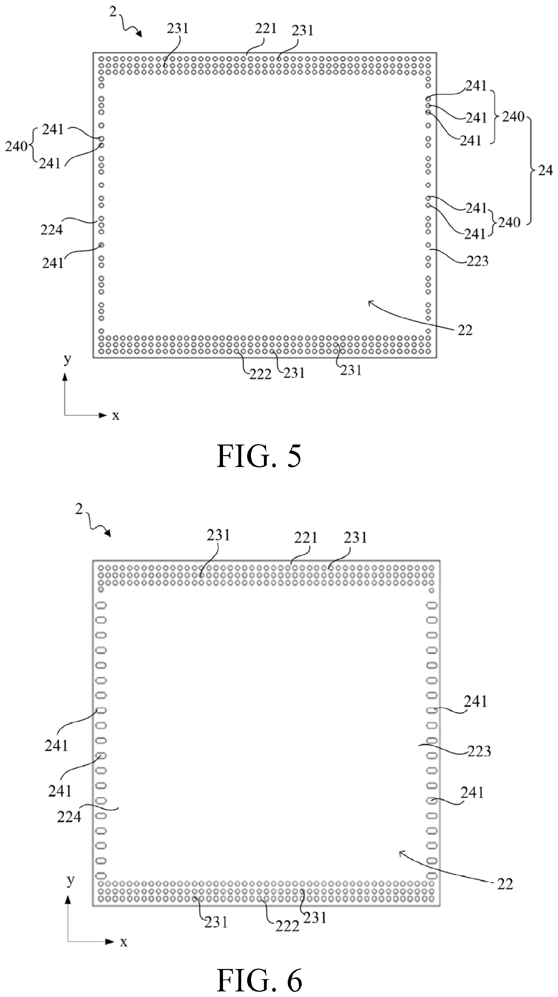

In some embodiments, the number of second solder balls 241 in each solder ball group 240 may be the same or different. As shown in FIG. 5, some solder ball groups 240 may include one second solder ball 241, some solder ball groups 240 may include two second solder balls 241, and some solder ball groups 240 may include three second solder balls 241. In practice, the solder ball group 240 may include four or more second solder balls 241, which are not exemplified or illustrated individually here.

As shown in FIGs. 5 to 8, the spacing between adjacent solder ball groups 240 may be the same. In FIGs. 6 and 7, each solder ball group 240 includes only one second solder ball 241, and the solder ball groups 240 are equally spaced along the second direction y. As shown in FIG. 8, the spacing between adjacent solder ball groups 240 may be different, and the solder ball groups 240 are unequally spaced along the second direction y.

The second-type solder balls 24 may be arranged in a column along the second direction y, as shown in FIGs. 5 to 7. The second-type solder balls 24 may be arranged in multiple columns along the second direction y, such as two columns as illustrated in FIG. 8. In practice, three or more columns may be possible.

In case the second-type solder balls 24 are arranged in multiple columns along the second direction y, for two adjacent columns of second-type solder balls 24, the spacing between adjacent solder ball groups 240 in a column close to the center of the interposer 2 is denoted as first spacing, and the spacing between adjacent solder ball groups 240 in a column close to an edge of the interposer 2 is denoted as second spacing, wherein a projection of the first spacing along the first direction x is covered by a projection of the second spacing along the first direction x. In this way, during molding process, the resistance of the second solder balls 241 to mold flow in the solder ball groups 240 of the column close to the edge can be reduced as much as possible, so that the mold flow can enter adjacent solder ball groups 240, and the molding yield is improved.

In an implementation, the first direction x is perpendicular to the second direction y.

In some non-limiting embodiments, the memory 1 may be a Dynamic Random Access Memory (DRAM). The DRAM may include a Low Power Double Data Rate SDRAM (LPDDR) and the like.

In an implementation, according to the Joint Electron Device Engineering Council (JEDEC) standard, for a DRAM in the hybrid Package-on-Package, the DRAM (such as LPDDR) has signal bumps for signal fan-out in two opposite directions, and is grounded in the other two directions. For ease of illustration, the signal fan-out direction of the signal bumps of the DRAM may be defined as the 12 o'clock and 6 o'clock directions, and the other two grounded directions may be defined as the 3 o'clock and 9 o'clock directions.

In some embodiments, the second surface 22 of the interposer 2 has a first periphery region 221 and a second periphery region 222 opposite to each other, wherein the first-type solder balls 23 are located in the first periphery region 221 and the second periphery region 222. And/or, the second surface 22 of the interposer 2 has a third periphery region 223 and a fourth periphery region 224 opposite to each other, wherein the second-type solder balls 24 are located in the third periphery region 223 and the fourth periphery region 224.

In some embodiments, the first periphery region 221, the second periphery region 222, the third periphery region 223 and the fourth periphery region 224 are distributed around the periphery of the second surface 22 of the interposer 2.

The first periphery region 221 and the second periphery region 222 correspond to the regions with signal bumps 11 of the DRAM, respectively, i.e., the 12 o'clock and 6 o'clock directions of the signal bumps for signal fan-out from the DRAM, where the first-type solder balls 23 fan out signals from the memory 1. The signal routing of the memory 1 merely occupies the first-type solder balls 23 in the first periphery region 221 and the second periphery region 222 of the interposer 2.

The third periphery region 223 and the fourth periphery region 224 correspond to the 3 o'clock and 9 o'clock directions of the DRAM, respectively. The second-type solder balls 24 disposed in the third periphery region 223 and the fourth periphery region 224 serve to support the SOC substrate 3 and the interposer 2.

In some embodiments, the cross-sections of the second-type solder balls 24 in a direction parallel to the second surface 22 are dog-bone shaped (also known as racetrack shaped or obround), as shown in FIG. 6.

In other embodiments, the cross-sections of the second-type solder balls 24 in a direction parallel to the second surface 22 are elliptical, as shown in FIGs. 7 and 8.

It should be noted that, the second-type solder balls 24 may all have dog-bone shaped cross-sections in a direction parallel to the second surface 22. The second-type solder balls 24 may all have elliptical cross-sections in a direction parallel to the second surface 22. Some second-type solder balls 24 may have dog-bone shaped cross-sections, and some second-type solder balls 24 may have elliptical cross-sections in a direction parallel to the second surface 22.

In yet other embodiments, the cross-sections of the second-type solder balls 24 in a direction parallel to the second surface 22 are circular, as shown in FIG. 5.

In an implementation, the first-type solder balls 23 are spherical, and have circular cross-sections in a direction parallel to the second surface 22.

In some embodiments, the cross-sections of the second-type solder balls 24 in a direction parallel to the second surface 22 are dog-bone shaped, and the second-type solder balls 24 have long sides extending along the second direction y, which have lengths greater than a diameter of the first-type solder ball 23.

The second-type solder balls 24 have short sides with lengths smaller than the diameter of the first-type solder ball 23.

It should be noted that, in a direction perpendicular to the second surface 22, the lengths of the long sides and/or short sides at the cross-sections of the second-type solder balls 24 at different distances from the second surface 22 may be different. It is only required that the length of the maximum long side of the second-type solder ball 24 is greater than the diameter of the first-type solder ball 23, and/or the length of the maximum short side of the second-type solder ball 24 is smaller than the diameter of the first-type solder ball 23.

In other embodiments, the cross-sections of the second-type solder balls 24 in a direction parallel to the second surface 22 are elliptical, and the second-type solder balls 24 have long axes extending along the second direction y, which have lengths greater than the diameter of the first-type solder ball 23.

The second-type solder balls 24 have short axes with lengths smaller than the diameter of the first-type solder ball 23.

It should be noted that, in a direction perpendicular to the second surface 22, the lengths of the long axes and/or short axes at the cross-sections of the second-type solder balls 24 at different distances from the second surface 22 may be different. It is only required that the length of the maximum long axis of the second-type solder ball 24 is greater than the diameter of the first-type solder ball 23, and/or the length of the maximum short axis of the second-type solder ball 24 is smaller than the diameter of the first-type solder ball 23.

In an implementation, the solder ball parameters of the first-type solder balls 23 and the solder ball parameters of the second-type solder balls 24 are determined based on at least one of the following parameters: a number of signal bumps of the memory, a layout of the signal bumps of the memory, a trace width of the interposer, a trace pitch of the interposer, a package size of the interposer, and the like.

The first-type solder balls 23 may include a plurality of first solder balls 231 arranged in an array along the first direction.

The solder ball parameters of the first-type solder balls 23 may include a diameter of the first solder ball and the spacing between adjacent first solder balls 231. The spacing between adjacent first solder balls 231 may include the spacing between the first solder balls 231 along the first direction x, and may also include the spacing along the second direction y.

In some embodiments, the spacing between adjacent first solder balls 231 refers to the spacing between edges of the first solder balls 231. In this case, the spacing between the solder ball groups 240 of the second-type solder balls 24 refers to the spacing between edges of two closest second solder balls 241 in two adjacent solder ball groups 240. For example, two adjacent solder ball groups are denoted as a first solder ball group and a second solder ball group respectively. Along the second direction y, the spacing between the first solder ball group and the second solder ball group refers to the spacing between edges of the second solder balls 241 that are closest to each other in the first solder ball group and the second solder ball group.

In other embodiments, the spacing between adjacent first solder balls 231 refers to the spacing between centers of the first solder balls 231. In this case, the spacing between the solder ball groups 240 of the second-type solder balls 24 refers to the spacing between centers of two closest second solder balls 241 in two adjacent solder ball groups 240. For example, two adjacent solder ball groups are denoted as a first solder ball group and a second solder ball group respectively. Along the second direction y, the spacing between the first solder ball group and the second solder ball group refers to the spacing between centers of the second solder balls 241 that are closest to each other in the first solder ball group and the second solder ball group.

In some embodiments, the solder ball parameters of the first-type solder balls 23 and the solder ball parameters of the second-type solder balls 24 may be determined in the following manner.

Based on a determination that the package form is a hybrid Package-on-Package, the solder ball parameters of the first-type solder balls 23, and a ball pad size and ball pad opening size for the first-type solder balls 23 on the interposer 2 are determined according to one or more of: the number of signal bumps of the memory 1, the layout of the signal bumps of the memory 1, the trace width of the interposer 2, the trace pitch of the interposer 2, the package size of the interposer 2, and the like.

The signal bump data information (e.g., Datasheet) of the memory 1 and design requirements of the SOC chip (die) are obtained, to determine the Package Size (PKG Size) of the interposer 2.

The layout of the first-type solder balls 23 in the first periphery region 221 and the second periphery region 222 of the interposer 2 and the spacing between adjacent first solder balls 231 in the first-type solder balls 23 are determined based on the trace orientation, the number and layout of signal bumps of the memory 1.

The spacing D between adjacent solder ball groups 240 of the second-type solder balls 24 along the second direction y and the spacing d between adjacent second solder balls 241 in the solder ball group 240 along the second direction y are determined based on the spacing between adjacent first solder balls 231 of the first-type solder balls 23. The spacing D between adjacent solder ball groups 240 is greater than the spacing d between adjacent second solder balls 241 in the solder ball group 240.

The spacing between adjacent first solder balls 231 of the first-type solder balls 23 may be the same as the spacing between the second solder balls 241 in the solder ball group 240. The spacing between adjacent first solder balls 231 of the first-type solder balls 23 may be less than the spacing between the second solder balls 241 in the solder ball group 240.

In some non-limiting embodiments, simulation may be used to simulate the arrangement of the second-type solder balls 241, and the optimal spacing between the solder ball groups 240 and the optimal spacing between adjacent second solder balls 241 in the solder ball group 240 may be determined according to the simulation results.

The solder ball types of the first-type solder balls 23 and the second-type solder balls 24 are determined according to engineering requirements and Outsourced Semiconductor Assembly and Testing (OSAT) capabilities. The solder ball types may include placement balls, electroplated balls, etc. That is, the first-type solder balls 23 and the second-type solder balls 24 may be formed by an automatic ball placement process or an electroplated ball process.

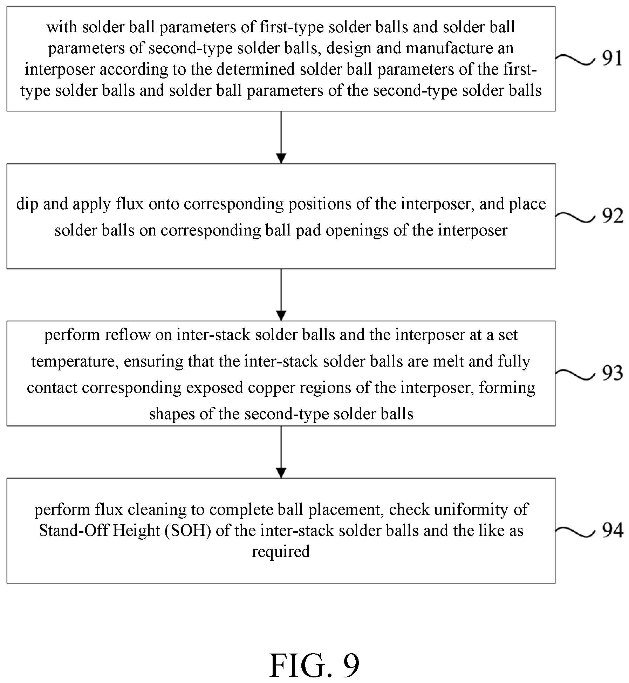

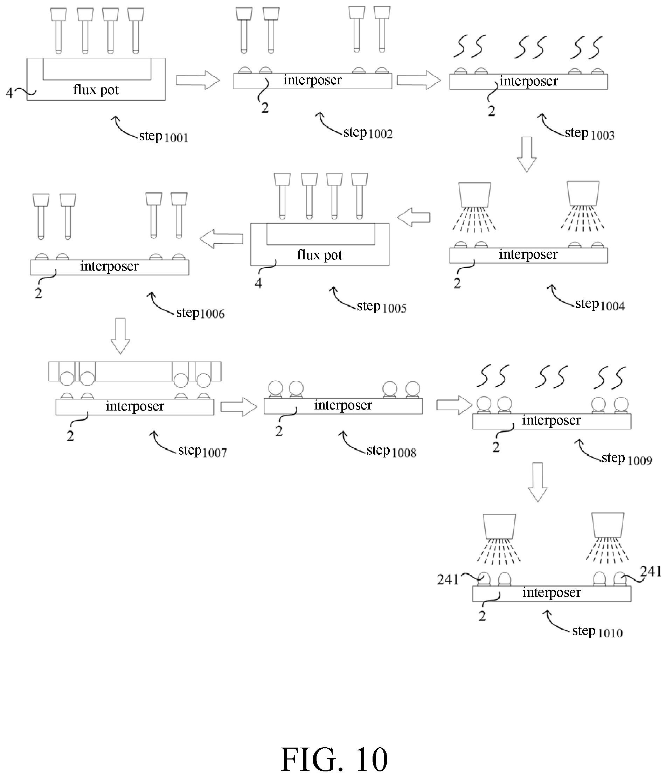

With reference to FIGs. 9 and 10, taking the second-type solder balls as an example, the process for forming the second-type solder balls by an automatic ball placement process may specifically include steps 91 to 94 as below.

At step 91, with the solder ball parameters of the first-type solder balls and the solder ball parameters of the second-type solder balls, the interposer is designed and manufactured according to the solder ball parameters of the first-type solder balls and the solder ball parameters of the second-type solder balls.

Specifically, the ball pad size and ball pad opening size for the first-type solder balls, and the ball pad size and ball pad opening size of the second-type solder balls on the interposer 2 are determined according to the solder ball parameters.

In case the cross-sections of the second-type solder balls in a direction parallel to the second direction are dog-bone shaped, the long sides of the second-type solder balls extend along the second direction, that is, along the flow direction of the mold flow. The long sides of the second-type solder balls are greater than the diameter of the first-type solder ball, and the short sides of the second-type solder balls are smaller than the diameter of the first-type solder ball.

In case the cross-sections of the second-type solder balls in a direction parallel to the second direction are elliptical, the long axes of the second-type solder balls extend along the second direction, that is, along the flow direction of the mold flow. The long axes of the second-type solder balls are greater than the diameter of the first-type solder ball, and the short axes of the second-type solder balls are smaller than the diameter of the first-type solder ball.

At step 92, flux is dipped and applied onto corresponding positions of the interposer, and the solder balls are placed on the corresponding ball pad openings of the interposer.

Solder balls may have a circular original shape, eliminating the need for special stencil design. Flux is dipped from the flux pot 4 and applied onto the corresponding positions of the interposer 2. Hot melt welding (reflow) is then performed, followed by flux cleaning. Flux is dipped again and applied onto the corresponding positions of the interposer 2. This process corresponds to steps 1001 to 1006 in FIG. 10.

The solder balls are placed on the ball pad openings. This process corresponds to steps 1007 to 1008 in FIG. 10.

At step 93, reflow is performed on the inter-stack solder balls and the interposer at a set temperature, ensuring that the inter-stack solder balls are melt and fully contact the corresponding exposed copper regions of the interposer, thereby forming the shapes of the second-type solder balls.

The set temperature may range from 230°C to 237°C.

Since the long sides or long axes of the solder balls (ball pad openings) are greater than the ball diameter of the first-type solder ball, the solders expand toward the long sides or long axes under the surface tension during reflow, thereby forming the shapes of the second-type solder balls. This process corresponds to step 1009 in FIG. 10.

At step 94, flux cleaning is performed to complete the ball placement. The uniformity of Stand-Off Height (SOH) of the inter-stack solder balls and the like may be checked as required.

Step 94 corresponds to step 1010 in FIG. 10.

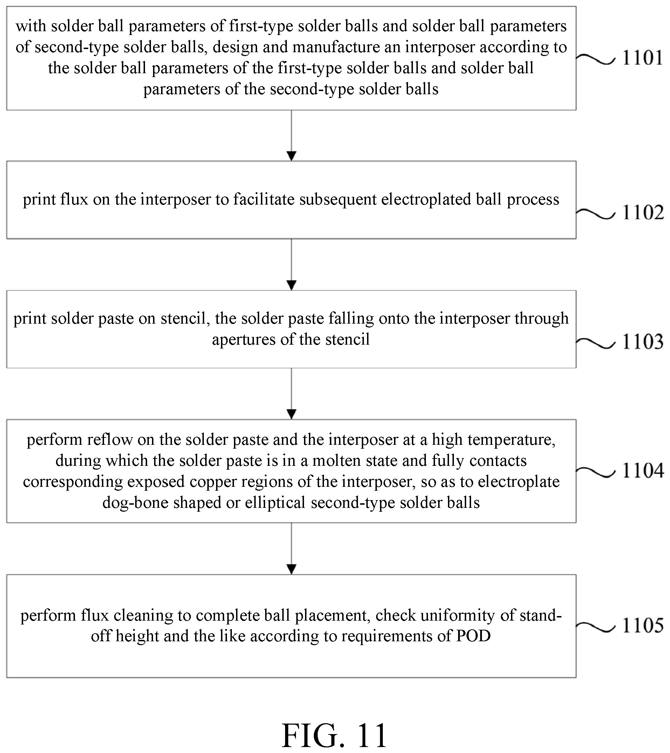

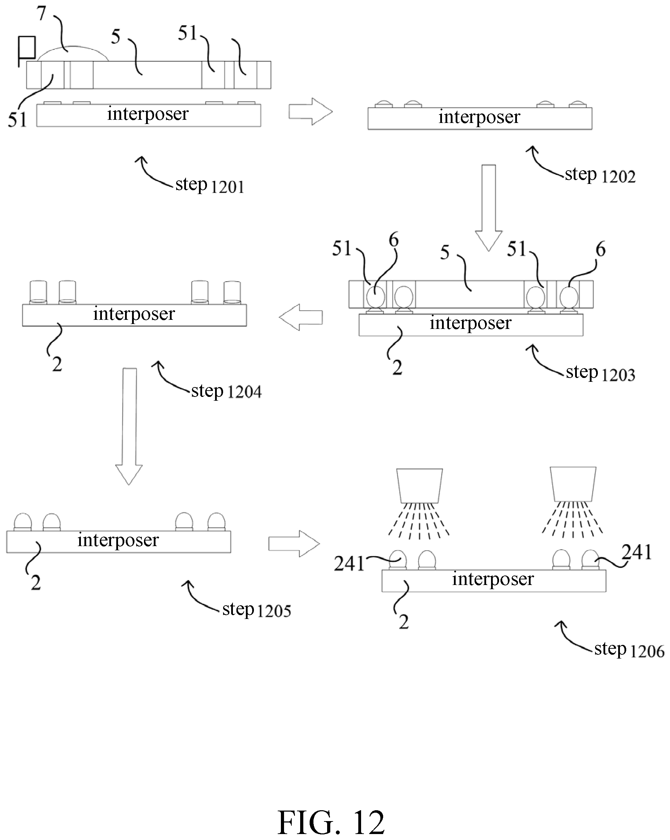

With reference to FIGs. 11 and 12, taking the second-type solder balls as an example, the process for forming the second-type solder balls by an electroplated ball process may specifically include steps 1101 to 1105 as below.

At step 1101, with the solder ball parameters of the first-type solder balls and the solder ball parameters of the second-type solder balls, the interposer is designed and manufactured according to the solder ball parameters of the first-type solder balls and the solder ball parameters of the second-type solder balls.

The detailed process of step 1101 may refer to step 91, and will not be repeated here.

At step 1102, flux is printed on the interposer to facilitate subsequent electroplated ball process.

This process corresponds to steps 1201 and 1202 in FIG. 12. Flux may be printed on the interposer 2 by manual printing. For example, flux 7 may be printed through apertures 51 of the stencil 5.

At step 1103, solder paste is printed on the stencil, wherein the solder paste falls onto the interposer through the apertures of the stencil.

The stencil 5 has a plurality of apertures 51, wherein the apertures 51 for forming the first-type solder balls have shapes adapted to the shapes of the first-type solder balls, and the apertures 51 for forming the second-type solder balls have shapes adapted to the shapes of the second-type solder balls. The solder paste 6 for forming the second-type solder balls is distributed in dog-bone shapes or elliptical shapes. The solder paste 6 for forming the first-type solder balls is distributed in circular shapes. This process corresponds to steps 1203 to 1204 in FIG. 12.

At step 1104, reflow is performed on the solder paste and the interposer at a high temperature, during which the solder paste is in a molten state and fully contacts the corresponding exposed copper regions of the interposer, so as to electroplate dog-bone shaped or elliptical second-type solder balls.

Since the long sides or long axes of the solder balls (ball pad openings) are greater than the ball diameter of the first-type solder ball, the solder paste 6 expands toward the long sides or long axes under the surface tension during reflow, thereby forming the shapes of the second-type solder balls. This process corresponds to step 1205 in FIG. 12.

At step 1105, flux cleaning is performed to complete the ball placement. The uniformity of stand-off height and the like may be checked according to the requirements of the Package Outline Drawing (POD).

Step 1105 corresponds to step 1206 in FIG. 12.

It should be understood that, in the present application, the term "and/or" merely describes a relationship between related objects, indicating that there may be three relationships. For example, A and/or B may indicate: A alone, both A and B, or B alone. In addition, the character "/" in the present application indicates that the related objects before and after it are in an "or" relationship.

The term "a plurality of" in the embodiments of the present application means two or more.

The descriptions such as first and second in the embodiments of the present application are only for illustration and distinguishing the described objects, do not imply any order, and do not represent any special limitation on the number of devices in the embodiments of the present application, and may not constitute any limitation on the embodiments of the present application.

Although the present application is disclosed as above, it is not limited thereto. Any person skilled in the art may make various changes and modifications without departing from the spirit and scope of the present application. Therefore, the protection scope of the present application shall be subject to the scope defined by the claims.

## Claims

1. A hybrid Package-on-Package structure, **characterized in that**, the hybrid Package-on-Package comprises:
a memory with signal bumps for transmitting signals;
an interposer with a first surface and a second surface opposite to each other, the first surface towards the memory, the second surface towards an SOC substrate, wherein the second surface is disposed with first-type solder balls arranged along a first direction and second-type solder balls arranged along a second direction, the first-type solder balls being connected to the signal bumps of the memory, the first-type solder balls for signal fan-out from the memory, the second-type solder balls for supporting the interposer and the SOC substrate, wherein the second-type solder balls are divided into a plurality of solder ball groups, each solder ball group including one or more second solder balls, a spacing between adjacent solder ball groups being greater than a spacing between adjacent second solder balls in the solder ball group along the second direction, wherein the first direction is different from the second direction;
the SOC substrate, which is in signal connection with the first-type solder balls.

2. The hybrid Package-on-Package structure of claim 1, **characterized in that**, the first direction is perpendicular to the second direction.

3. The hybrid Package-on-Package structure of claim 1 or 2, **characterized in that**, the second surface of the interposer has a first periphery region and a second periphery region opposite to each other, wherein the first-type solder balls are located in the first periphery region and the second periphery region; and/or, the second surface of the interposer has a third periphery region and a fourth periphery region opposite to each other, wherein the second-type solder balls are located in the third periphery region and the fourth periphery region.

4. The hybrid Package-on-Package structure of claim 1, **characterized in that**, cross-sections of the second-type solder balls in a direction parallel to the second surface are circular, dog-bone shaped, or elliptical.

5. The hybrid Package-on-Package structure of claim 4, **characterized in that**, the first-type solder balls are spherical, the cross-sections of the second-type solder balls in the direction parallel to the second surface are dog-bone shaped, wherein the second-type solder balls have long sides extending along the second direction, the long sides of the second-type solder balls having lengths greater than a diameter of the first-type solder ball; or, the cross-sections of the second-type solder balls in the direction parallel to the second surface are elliptical, wherein the second-type solder balls have long axes extending along the second direction, the long axes of the second-type solder balls having lengths greater than the diameter of the first-type solder ball.

6. The hybrid Package-on-Package structure of claim 5, **characterized in that**, the cross-sections of the second-type solder balls in the direction parallel to the second surface are dog-bone shaped, the second-type solder balls having short sides with lengths smaller than the diameter of the first-type solder ball; or, the cross-sections of the second-type solder balls in the direction parallel to the second surface are elliptical, the second-type solder balls having short axes with lengths smaller than the diameter of the first-type solder ball.

7. The hybrid Package-on-Package structure of claim 1, **characterized in that**, the second-type solder balls are formed by an automatic ball placement process; or, the second-type solder balls are formed by an electroplated ball process.

8. The hybrid Package-on-Package structure of claim 1, **characterized in that**, solder ball parameters of the first-type solder balls and solder ball parameters of the second-type solder balls are determined based on at least one of the following parameters: a number of the signal bumps of the memory, a layout of the signal bumps of the memory, a trace width of the interposer, a trace pitch of the interposer, and a package size of the interposer.

9. The hybrid Package-on-Package structure of claim 1, **characterized in that**, the second-type solder balls are arranged in one or more columns along the second direction.

10. The hybrid Package-on-Package structure of claim 9, **characterized in that**, the second-type solder balls are arranged in multiple columns along the second direction, for two adjacent columns of the second-type solder balls, a spacing between adjacent solder ball groups in a column close to a center of the interposer being denoted as a first spacing, and a spacing between adjacent solder ball groups in a column close to an edge of the interposer being denoted as a second spacing, wherein a projection of the first spacing along the first direction is covered by a projection of the second spacing along the first direction.
